# EUROPEAN PATENT APPLICATION

(11) **EP 4 697 881 A1**
(43) Date of publication of application: **18.02.2026**
(21) Application number: 25194656.2
(22) Date of filing: 07.08.2025
(51) Int. Cl.: H05K 7/20, E04B 5/48, E04F 15/024, G06F 1/20

(54) **FLUID DISTRIBUTION SYSTEM**

(30) Priority: 16.08.2024 US 202418806841
(71) Applicant: Schneider Electric IT Corporation, Foxboro, MA 02035 (US)
(72) Inventor: SHEEHAN, Stuart Michael, ANDOVER, 01810 (US); RIMLER, Barry, ANDOVER, 01810 (US); BUNGER, Robert Eugene, ANDOVER, 01810 (US)
(74) Representative: Plasseraud IP

(57) **Abstract**

A piping-container module includes a module body, a first portion formed in the module body, and a second portion formed in the module body. The first portion is configured to receive first liquid-cooling piping coupled to a cooling-distribution unit. The second portion is configured to receive second liquid-cooling piping coupled to an equipment rack. The piping-container module further includes a seal coupled to the first portion and the second portion and a walking platform configured to be coupled to the module body. The walking platform is configured to enable a person to walk on the piping-container module.

## Description

### BACKGROUND OF INVENTION

### Field of the Invention

The present disclosure relates generally to data centers, and more particularly to an underfloor fluid distribution systems that is configured to provide liquid-cooling to IT equipment supported by equipment racks.

### Discussion of Related Art

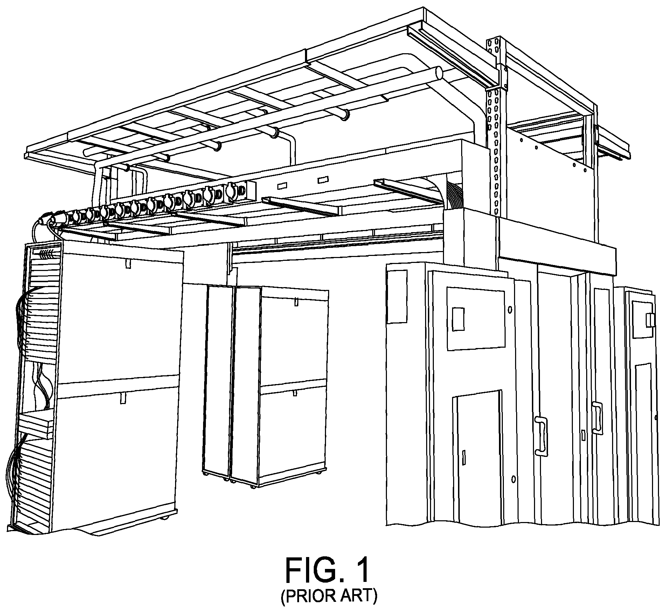

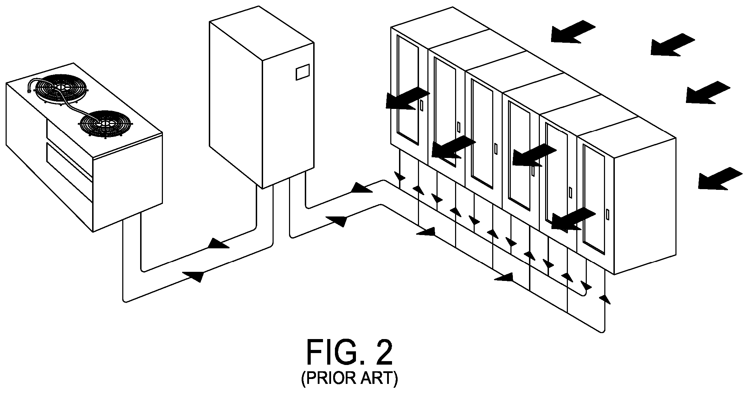

Existing data centers provide liquid-cooling to IT equipment supported by equipment racks in one of two ways. One approach, shown in FIG. 1, is to provide liquid-cooling through an overhead cooling system. Liquid supply and return headers are mounted overhead in which piping is suspended from a ceiling or mounted overhead on a support frame. Another approach, shown in FIG. 2, is to provide cooling through a raised floor (not shown) on which the equipment racks are supported. However, while the raised floor facilitates transferring liquid coolant beneath the equipment rack, this solution requires raising the entire data center or by creating a partial basement or space below the floor of the data center whitespace.

Currently available cooling-distribution units (CDUs), which are configured to distribute fluid to the various equipment racks, are mainly packaged in either rack- or skid-type form factors, depending on size. Larger CDUs may be on skids and placed in the gray space within the data center. Medium and pod CDUs are often in rack form factor and take up valuable whitespace within a row of equipment racks within the data center.

### SUMMARY

Different aspects of the present disclosure are directed to piping-container module, systems and methods as per the appended claims.

### BRIEF DESCRIPTION OF DRAWINGS

Various aspects of at least one embodiment are discussed below with reference to the accompanying figures, which are not intended to be drawn to scale. The figures are included to provide an illustration and a further understanding of the various aspects and embodiments and are incorporated in and constitute a part of this specification but are not intended as a definition of the limits of any particular embodiment. The drawings, together with the remainder of the specification, serve to explain principles and operations of the described and claimed aspects and embodiments. In the figures, each identical or nearly identical component that is illustrated in various figures is represented by a like numeral. For purposes of clarity, not every component may be labeled in every figure. In the figures:
FIG. 1 is a perspective view of a portion of a data center having an overhead fluid distribution system of a known system, the overhead fluid distribution system being configured to cool electronic equipment within an equipment rack;
FIG. 2 is a schematic perspective view of a portion of a data center having a raised floor fluid distribution system of a known system, the raised floor fluid distribution system being configured to cool electronic equipment within an equipment rack;
FIG. 3 is a perspective view of a portion of a data center having an underfloor fluid distribution system of an embodiment of the present disclosure;
FIG. 4 is a perspective view of a piping-container module of the underfloor fluid distribution system of one embodiment of the present disclosure;
FIG. 5 is a perspective view of a piping-container module of the underfloor fluid distribution system of another embodiment of the present disclosure;
FIG. 6 is a plan view of two manifolds of the piping-container module;
FIG. 7 is a schematic view of the underfloor fluid distribution system;
FIG. 8 is a legend to be used with the schematic view of FIG. 7; and
FIG. 9 is a view of a bulkhead seal used with the underfloor fluid distribution system.

### DETAILED DESCRIPTION

Examples of the methods and systems discussed herein are not limited in application to the details of construction and the arrangement of components set forth in the following description or illustrated in the accompanying drawings. The methods and systems are capable of implementation in other embodiments and of being practiced or of being carried out in various ways. Examples of specific implementations are provided herein for illustrative purposes only and are not intended to be limiting. **In** particular, acts, components, elements and features discussed in connection with any one or more examples are not intended to be excluded from a similar role in any other examples.

Also, the phraseology and terminology used herein is for the purpose of description and should not be regarded as limiting. Any references to examples, embodiments, components, elements or acts of the systems and methods herein referred to in the singular may also embrace embodiments including a plurality, and any references in plural to any embodiment, component, element or act herein may also embrace embodiments including only a singularity. References in the singular or plural form are not intended to limit the presently disclosed systems or methods, their components, acts, or elements. The use herein of "including," "comprising," "having," "containing," "involving," and variations thereof is meant to encompass the items listed thereafter and equivalents thereof as well as additional items.

References to "or" may be construed as inclusive so that any terms described using "or" may indicate any of a single, more than one, and all of the described terms. **In** addition, in the event of inconsistent usages of terms between this document and documents incorporated herein by reference, the term usage in the incorporated features is supplementary to that of this document; for irreconcilable differences, the term usage in this document controls.

Data centers include rows of equipment racks, each being configured to support IT equipment. Data centers further include several methods to cool IT equipment, including but not limited to central cooling systems, in-row cooling systems, and dedicated liquid-cooling systems. Such liquid-cooling systems are configured to deliver cooled liquid from a cooling-distribution unit (CDU) to cool IT equipment. As noted above, cooled liquid can be delivered to the IT equipment supported by the equipment racks by an overhead cooling system. Liquid supply and return headers are mounted overhead above the equipment racks, with piping being suspended from a ceiling or mounted overhead on a support frame. Cooled liquid further can be delivered to the IT equipment supported by the equipment racks by a cooling system provided within a raised floor on which the equipment racks are supported. Having raised floors facilitates transferring liquid coolant to/from equipment racks from beneath rather than from the ceiling. But raised floors cannot always be installed (e.g., on slab), and they require raising an entire data center or by creating a partial basement or space below the floor of the data center whitespace, even in areas where bottom-fed liquid-cooling is unnecessary.

Embodiments of the underfloor fluid distribution system disclosed herein provide liquid-cooling that can be transferred to and from equipment racks from beneath the equipment racks in select parts of the data center, even in locations where raised floors cannot be installed.

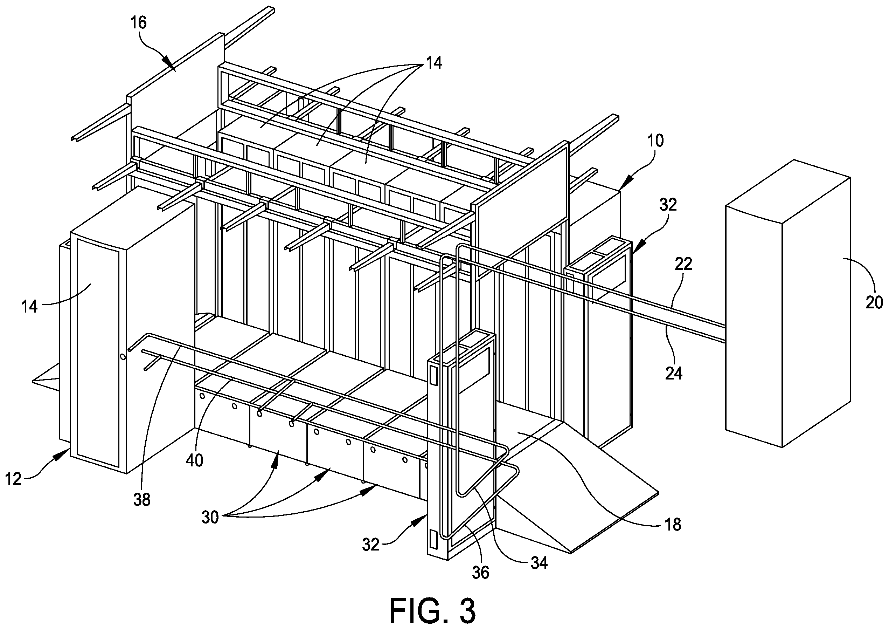

Referring to the drawings, and more particular to FIG. 3, a portion of a data center includes a first row of equipment racks, generally indicated at 10, and a second row of equipment racks, generally indicated at 12. The first row of equipment racks 10 and the second row of equipment racks 12 each include several equipment racks, each indicated at 14. As shown, most of the equipment racks 14 are removed from the second row of equipment racks 12 for illustration purposes to show aspects of the present disclosure.

A typical data center may be designed to accommodate multiple rows of equipment racks. A data center may include large data centers, smaller data centers, equipment rooms, computer rooms, and even wiring closets having more than one equipment rack. In addition, any reference to "equipment rack," "enclosure," "rack enclosure," and/or "electronics cabinet," or any variation thereof, are used interchangeably herein and are meant to describe a structure suitable for supporting and organizing electronic equipment.

Each equipment rack 14 may be configured to include a frame or housing adapted to support electronic components, such as data processing, networking and telecommunications equipment. The housing includes a front, back, sides, a bottom and a top. The front of each equipment rack 14 may include a front door so as to enable access into the interior of the equipment rack 14. A lock may be provided to prevent access into the interior of the equipment rack 14 and the equipment housed by the equipment rack 14. The sides of the equipment rack 14 may include at least one panel to enclose the interior region of the rack. The back of the equipment rack 14 may also include at least one panel or a back door or doors to provide access to the interior of the equipment rack 14 from the back of the rack. In certain embodiments, the side and back panels, as well as the front door and the rear door(s), may be fabricated from perforated sheet metal, for example, to allow air to flow into and out of the interior region of the equipment rack 14. In other embodiments, the front door may include a removable panel, either perforated, partially perforated or solid.

Each equipment rack 14 is modular in construction and configured to be rolled into and out of position, e.g., within a row of the data center. Casters (not shown) may be secured to the bottom of each equipment rack 14 to enable the equipment rack 14 to roll along the floor of the data center. Once positioned, leveling feet may be deployed to securely ground the equipment rack 14 in place within the row. Once in position, or prior to positioning the equipment rack 14, electronic equipment may be positioned in the interior region of the equipment rack 14. For example, the electronic equipment may be placed on shelves or with rack-mounted connectors secured within the interior region of the equipment rack 14.

Cables providing electrical and data communication may be provided through the top of the equipment rack 14 either through a cover (or "roof") at the top of the equipment rack 14 having openings formed therein or through an open top of the equipment rack 14. In this embodiment, the cables may be strung along the roofs of the rack or be provided in the cable distribution troughs of embodiments of the disclosure described below. In another embodiment, the cables may be disposed within a raised floor and connected to the electronic equipment through the bottom of the equipment rack 14. With both configurations, power and communication lines (and any other related component) may be provided to the equipment racks 14. It should be understood that a cable may reference any type of cable, cord or device used to provide communication and/or power from the data center to the equipment racks or between the equipment racks 14.

In embodiments of this disclosure, data centers are made up of IT equipment housed by the equipment racks or in some embodiments by open frame racks. Data and power cabling are required to interconnect IT equipment in a single rack as well as across multiple racks in the data center. In addition, electrical conduits and piping are often required for cooling equipment. It is desirable to support, organize and manage such cabling and piping by use of overhead cable troughs, cable ladders and partitions. In the shown embodiment, an overhead support structure, generally indicated at 16, is positioned over an aisle 18 between the first row of equipment racks 10 and the second row of equipment racks 12. The overhead support structure 16 is configured to support data and power cabling provided to connect the IT equipment supported by the equipment racks 14.

In some embodiments, IT equipment within the equipment racks 14 is cooled by liquid-cooling, which includes delivering a process fluid to cooling plates used to cool the IT equipment. Liquid-cooling can also be used in combination with other traditional cooling methods, such as those that use air to cool IT equipment within the equipment racks 14. Other types of cooling may also be employed, such as in-row cooling units. In one embodiment, water is used to provide liquid-cooling. The liquid-cooling fluid, sometimes referred to herein as coolant, is cooled by mechanical equipment and distributed by a cooling-distribution unit (CDU) 20. Suitable piping is provided to deliver relatively chilled coolant to the equipment racks 14 and to return relatively heated coolant to the CDU 20. In the shown embodiment, pipe 22 is provided to deliver relatively chilled coolant from the CDU 20 to the equipment racks 14 and pipe 24 is provided to deliver relative heated coolant from the equipment racks 14 to the CDU 20.

A system, sometimes referred to as a platform, is provided to distribute and collect coolant to and from the equipment racks 14 is disclosed herein. In one embodiment, the system includes several piping-container modules, each generally indicated at 30, which are positioned in between the first row of equipment racks 10 and the second row of equipment racks 12 within the aisle 18. In one embodiment, the system includes six piping-container modules 30 arranged within the aisle 18; however, any number of piping-container modules 30 may be provided depending on the length of the aisle. The system further includes one or more (optional) transition cabinets, each indicated at 32, to transfer relatively chilled coolant to and return relatively heated coolant from the piping-container modules 30. Specifically, the pipe 22 is connected to the transition cabinet 32 to deliver relatively chilled coolant from the CDU 20 to the transition cabinet 32 and the pipe 24 is connected to the transition cabinet 32 to deliver relatively warmed coolant from the transition cabinet 32 to the CDU 20 for cooling.

The transition cabinet 32 is in fluid communication with the piping-container modules 30 by pipe 34, sometimes referred to herein as a first inlet pipe, that extends from the transition cabinet 32 to the piping-container modules 30 to deliver relatively chilled coolant from the transition cabinet 32 to the piping-container modules 30 and by pipe 36, sometimes referred to herein as a first outlet pipe, that extends from the piping-container modules 30 to the transition cabinet 32 to return relatively warmed coolant from the piping-container modules 30 to the transition cabinet 32. Pipes 34, 36 are sometimes referred to together as first liquid-cooling piping. The transition cabinet 32 provides fluid communication from pipes 22, 24 to pipes 34, 36, respectively, to deliver relatively chilled coolant from the CDU 20 to the piping-container modules 30 and to deliver relatively heated coolant from the piping-container modules 30 to the CDU 20. The purpose and configuration of the piping-container modules 30 will be described in greater detail below.

As shown in FIG. 3, the equipment rack 14 of the second row of equipment racks 12 is in fluid communication with the piping-container modules 30 by a portion 38 of pipe 34, sometimes referred to herein as a second inlet pipe, that extends from the piping-container modules 30 to deliver relatively chilled coolant to the IT equipment supported within the equipment racks 14 and by a portion 40 of pipe 36, sometimes referred to herein as a second outlet pipe, that extends from the IT equipment supported by the equipment racks 14 to the piping-container modules 30 to return relatively heated coolant to the piping-container modules 30. Portions 38, 40 of pipes 34, 36, respectively, are sometimes referred to herein as second liquid-cooling piping.

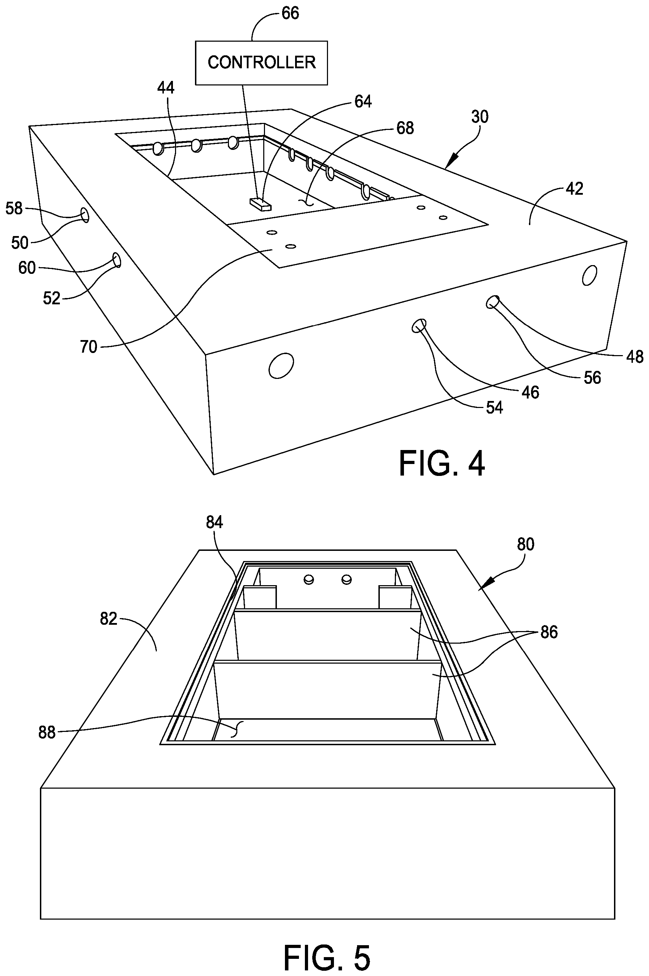

Referring additionally to FIG. 4, in one embodiment, the piping-container module 30 includes a module body 42, which in the shown embodiment is a rectangular-cuboid structure that is configured to receive piping in the manner described in greater detail below. Specifically, the module body 42 of the piping-container module 30 includes a basin 44 formed therein that is sized to receive the piping and components of the piping-container module 30 therein. As shown, the module body 42 of the piping-container module 30 includes a width that extends across the aisle 18 between the first row of equipment racks 10 and the second row of equipment racks 12, a length that is approximately the same width as the equipment rack 14, and a height suitable to support the piping within a space provided in the module body 30. The size and shape of the module body 42 of the piping-container module 30 can be selected based on the intended use of the piping-container module 30, including the width of the aisle, the length of the aisle, and the desired height.

The module body 42 has a first portion formed in the module body 42 to receive the first liquid-cooling piping, i.e., the portion 38 of the pipe 34 and the portion 40 of the pipe 36 that enters the module body 42, to and from the transition cabinet 32, and a second portion formed in the module body 42 to receive second liquid-cooling piping, i.e., the portion 38 of the pipe 34 and the portion 40 of the pipe 36, to and from the equipment rack 14. Specifically, the first portion includes a first opening 46 formed in the module body 42, the first opening 46 being configured to receive the pipe 34 or the portion 38 of the pipe 34 of the first liquid-cooling piping, and a second opening 48 formed in the module body 42, the second opening 48 being configured to receive the pipe 36 or the portion 40 of the pipe 36 of the first liquid-cooling piping. The second portion includes a third opening 50 formed in the module body 42, the third opening 50 being configured to receive the portion 38 of the pipe 34 of the second liquid-cooling piping, and a fourth opening 52 formed in the module body 42, the fourth opening 52 being configured to receive the portion 40 of the pipe 36 of the second-liquid-cooling piping. In one embodiment, the first opening 46 and the second opening 48 are formed in a shorter side of the module body 42 and the third opening 50 and the fourth opening 52 are formed in the longer side of the module body 42, with each opening 46, 48, 50, 52 being in fluid communication with the basin 44 formed in the module body 42. One should note that the positioning of openings 46, 48, 50, 52 may follow different configurations, depending on the configuration of the piping.

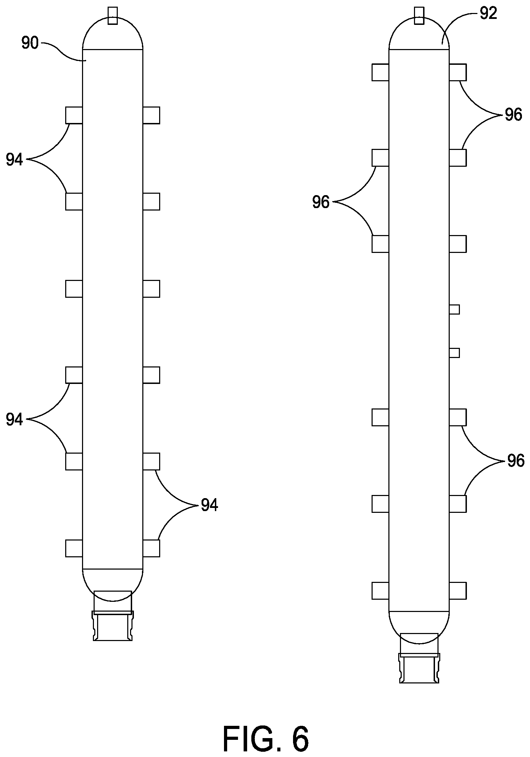

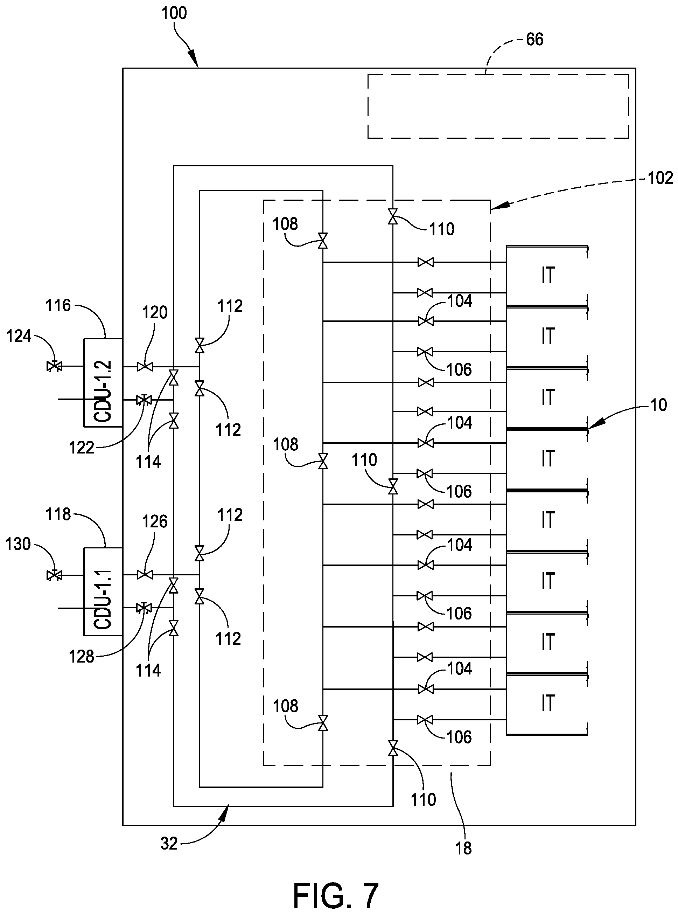

The arrangement is such that the pipe 34 and the pipe 36 of the first portion and the portion 38 of the pipe 34 and the portion 40 of the pipe 36 of the second portion are coupled to piping and valves (shown in FIG. 7) disposed within the basin 44 formed in the module body 42 to control the flow of coolant within the piping-container module 30 and between piping-container modules 30 and IT equipment supported by the equipment racks 14. Alternatively, or in addition to the piping and valves, the pipe 34 and the pipe 36 of the first portion and the portion 38 of the pipe 34 and the portion 40 of the pipe 36 of the second portion are coupled a manifold (such as the manifolds 90, 92 shown in FIG. 6) disposed within the basin 44 formed in the module body 42. The pipe 34 is configured to connect the module body 42 to the CDU 20 to deliver relatively chilled coolant to the module body 42, the pipe 36 is configured to connect the module body 42 to the CDU 20 to return relatively heated coolant to the CDU 20, the portion 38 of the pipe 34 is configured to connect the module body 42 to the equipment rack 14 to deliver the relatively chilled coolant to the equipment rack 14**,** and the portion 40 of the pipe 36 is configured to connect the module body 42 to the equipment rack 14 to return the relatively heated coolant to the module body 42.

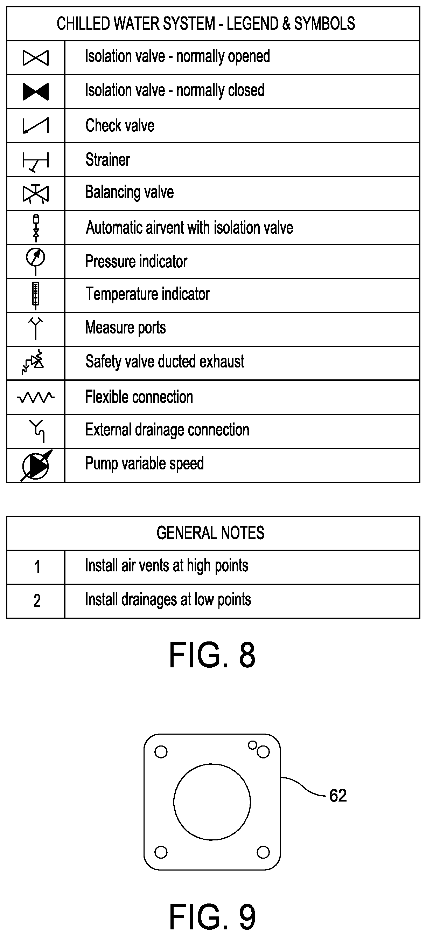

The first liquid-cooling piping and the second liquid-cooling piping may be sealed to the module body 42 by a first seal coupled to the first portion of the module body 42 and a second seal coupled to the second portion of the module body 42. In one embodiment, the first seal includes a first sealing member 54 secured to the module body 42 at the first opening 46 and a second sealing member 56 secured to the module body 42 at the second opening 48. The first sealing member 54 is configured to seal the pipe 34 or the portion 38 of the pipe 34 and the second sealing member 56 is configured to seal the pipe 36 or the portion 40 of the pipe 36. The second seal includes a third sealing member 58 secured to the module body 42 at the third opening 50 and a fourth sealing member 60 secured to the module body 42 at the fourth opening 52. The third sealing member 58 is configured to seal the portion 38 of the pipe 34 and the fourth sealing member 60 is configured to seal the portion 40 of the pipe 36. The first, second, third, and fourth sealing members 54, 56, 58, 60, in one embodiment, each embody a bulkhead fitting 62, which is illustrated in FIG. 9. The bulkhead fittings 62 are each configured to be secured to the module body 42 by fasteners, such as screw fasteners.

Referring back to FIG. 4, in one embodiment, the piping-container module 30 includes a leak detector 64 disposed within the basin 44 of the module body 42 to detect fluid leakage from the liquid-cooling piping, valves and manifold(s) within the basin 44 of the module body 42. In the shown embodiment, the leak detector 64 is coupled to a controller, indicated at 66, which may be associated with the data center, the equipment racks, and/or some other type of control system of the liquid-cooling system, to notify an operator of a detected leak. Any suitable leak detector may be employed to detect the presence of fluid in the basin 44 of the module body 42 of the piping-container module 30.

The basin 44 of the module body 42 further includes a liner 68 disposed within the basin 44 to ensure that fluid is contained within the basin 44 of the module body 42. The liner may be fabricated from any suitable water-resistant or waterproof material to contain fluid within the basin 44 in the event of a leak of the first liquid-cooling piping and/or the second liquid-cooling piping within the basin 44. The sealing members 54, 56, 58, 60 and the liner 68 may together be referred to as a "seal" that is coupled to the first portion and the second portion of the module body 42 of the piping-container module 30. The sealing members 54, 56, 58, 60 and the liner 68 are configured to retain fluid within the basin 44 of the module body 42 in the event of a fluid leak within the piping-container module 30.

The piping-container modules 30 are disposed within the aisle 18 and are configured to support persons walking over the piping-container modules 30 within the aisle 18. The piping-container modules 30 each include one or more walking platforms. With the embodiment of the piping-container module 30 shown in FIG. 4, the walking platform may include several panels or sections, each indicated at 70, that extend over the width of the basin 44 of the module body 42 and supported by an edge formed at the opening of the basin 44 in the module body 42. Each panel 70 can include one or more finger hole formed therein to enable an operator to remove the panel to access the basin 44 of the module body 42 and thus access the first liquid-cooling piping and the second liquid-cooling piping within the basin 44. The walking platform is configured to enable a person to walk on the piping-container module 30 while enclosing the basin 44 of the module body 42. Thus, a person walking between the first row of equipment racks 10 and the second row of equipment racks 12 is capable on walking on the panels 70 of the piping-container modules 30, with the piping container modules 30 protecting the piping, valves and manifolds disposed within the basin 44 of the module body 42. The walking platforms of the piping-container modules 30 lie along a common plane to enable the person to easily traverse the piping-container modules 30.

Referring to FIG. 5, another embodiment of the piping-container module is generally indicated at 80. The piping-container module 80 includes a module body 82 having a basin 84 formed therein. As shown, the basin 84 may include several optional sectioned walls, each indicated at 86, provided within the basin 84 of the module body 82 to segment the basin 84 into separate sections. Further, the piping-container module 80 includes a liner 88 within the basin 84 of the module body 82. Openings in the sides of the module body 82 can be formed in the field to accommodate varying configurations.

Referring to FIG. 6, the basin 44 of the module body 42 of the piping-container module 30 may include two manifolds 90, 92 provided to service IT equipment in the rows of equipment racks 10, 12 on either side of the piping-container module. As shown, the first manifold 90 includes several fittings, each indicated at 94, provided along a length of the first manifold. Similarly, a second manifold 92 includes several fittings, each indicated at 96, provided along a length of the second manifold. The lengths of the manifolds 90, 92 and the number of respective fittings 94, 96 can be varied depending on the intended use of the piping-container module 30.

Referring to FIGS. 7 and 8, a portion of an IT room is generally indicated at 100. The IT room 100 may form part of a data center. As shown, the IT room 100 includes the row of equipment racks 10 having several equipment racks, which are provided along the aisle 18 within the IT room. Although not shown, the IT room 100 further may include the other row of equipment racks 12 having several equipment racks spaced from the row of equipment racks 10 across the aisle 18. A liquid-containment assembly, generally indicated at 102, embodying several piping-container modules, e.g., piping-container modules 30, is provided within the aisle 18 adjacent to the row of equipment racks 10. The liquid-containment assembly 102 includes a plurality of inlet valves, each indicated at 104, which are each configured to control the delivery of relatively chilled coolant to IT equipment supported within the equipment racks, and a plurality of outlet valves, each indicated at 106, which are each configured to control the return of relatively heated coolant from the IT equipment. The valves 104, 106 are provided in the piping-container modules that constitute the liquid-containment assembly 102.

The liquid-containment assembly 102 further includes three valves, each indicated at 108, which are in fluid communication with the inlet valves 104, and three valves, each indicated at 110, which are in fluid communication with the outlet valves 106. The three valves 108 are in fluid communication with four valves, each indicated at 112, of the transition cabinet 32 to control the delivery of relatively chilled coolant. Similarly, the three valves 110 are in fluid communication with four valves, each indicated at 114, of the transition cabinet 32 to control the return of relatively warmed coolant. In the shown embodiment, although there are three valves 108, 110 and four valves 112, 114, any number of valves can be provided to control the delivery and return of coolant within the system.

In one embodiment, two CDUs 116, 118 are provided to deliver relatively chilled coolant to and receive relatively heated coolant from the row of equipment racks 10. As shown, CDU 116 is in fluid communication with valves 108, 112 by valve 120 to control the delivery of relatively chilled coolant to the row of equipment racks 10, and in fluid communication with valves 110, 114 by valve 122 to control the return of relatively heated coolant to the CDU. Another valve 124 is provided to deliver relatively chilled coolant to the CDU 116. Similarly, CDU 118 is in fluid communication with valves 108, 112 by valve 126 to control the delivery of relatively chilled coolant to the row of equipment racks 10, and in fluid communication with valves 110, 114 by valve 128 to control the return of relatively heated coolant to the CDU. Another valve 130 is provided to deliver relatively chilled coolant to the CDU 118.

In one embodiment, a method of distributing coolant from a cooling-distribution unit to at least one equipment rack containing electronic equipment requiring cooling. The method includes receiving relatively chilled coolant through a first portion of a piping-container module from first liquid-cooling piping coupled to the cooling-distribution unit, delivering the relatively chilled coolant through a second portion of the piping-container module from second liquid-cooling piping coupled to the at least one equipment rack, providing a seal to seal the first portion and the second portion, and providing a walking platform configured to enable a person to walk on the first liquid-cooling piping and the second liquid-cooling piping. The method further may include coupling a first inlet pipe and a first outlet pipe of the first portion and a second inlet pipe and a second outlet pipe of the second portion to piping and valves disposed within a basin formed in a module body of the piping-container module. In addition to or alternatively, the method further may include coupling the first inlet pipe and the first outlet pipe of the first portion and the second inlet pipe and the second outlet pipe of the second portion to at least one manifold disposed within a basin formed in the module body. The method further may include connecting the module body to the cooling-distribution unit with the first inlet pipe to deliver relatively chilled coolant to the module body, connecting the module body to the cooling-distribution unit with the first outlet pipe to return relatively heated coolant to the cooling-distribution unit, connecting the module body to the equipment rack with the second inlet pipe to deliver the relatively chilled coolant to the equipment rack, and connecting the module body to the equipment rack with the second outlet pipe to return the relatively heated coolant to the module body. The method further may include detecting a leak within a basin of the module body of the piping-container module.

In some embodiments, a piping-container module with portions for receiving piping from a cooling-distribution unit and a piping from an equipment rack is placed between the backs of two rows of equipment racks.

In some embodiments, piping-container module includes a seal and a walking platform.

In some embodiments, the piping-container may include an opening configured to receive piping and for sending piping to the equipment rack.

In some embodiments, the piping-container further may include a structure that can be walked on for accessing open-rear racks.

In some embodiments, the piping-container further may be configured to prevent leaks from the piping used to deliver liquid-cooling to and from the IT equipment supported by the equipment racks.

In some embodiments, the piping-container further includes a basin to prevent leaks from escaping.

In some embodiments, the piping-container further includes a leak detector to detect leakage within the piping-container.

In some embodiments, the piping-container is configured to separate distribution piping and manifolds from the IT equipment, thereby mitigating risk of equipment damage from fluid leaks.

In some embodiments, the piping-container module provides CDU functionality without the traditional whitespace footprint penalty of floor mounted CDUs.

In some embodiments, the piping-container modules facilitate an easy cooling fluid interface between equipment racks and pod fluid distribution.

In some embodiments, the basin of the module body of the piping-container module contains hydronic distribution equipment (manifolds, valves, pumps, and heat exchangers), which are used to distribute cooling fluid to liquid-cooled IT equipment provided in equipment racks in the. The basin can be sealed with a liner or construction method, such as to contain any potential fluid leaks and prevent damage to IT equipment. Additionally, side walls of the basin are used as the interface point of the module body of the piping-container module with the aid of seals, e.g., bulkhead fittings. The seals may be configured to include quick or dripless connections to hoses and rack manifolds.

In some embodiments, the piping-container modules create a raised floor height, e.g., 15 inches, that can include steps or ramps on the ends of the modules to provide access. The raised floor surface created by the piping-container modules may use removable floor tiles, e.g., walking panels, for general access, with specific removable covers for valve and piping access.

In some embodiments, transition cabinets can be provided at the ends of the aisle to transition piping from overhead to the raised center aisle to the piping-container modules.

In some embodiments, the elevated piping-container modules create an underfloor compartment in the center aisle that is effectively sealed and separates the water distribution from the racks and IT equipment. This system avoids the leak exposure of traditional overhead distribution, while also not requiring the capital expenditure of a full raised floor. The elevated compartment also creates a space for CDU functionality that does not require any whitespace footprint.

In some embodiments, the side walls of the piping-container module create a natural "stop rail" and space to locate the transition to in rack fluid distribution. The use of seals, e.g., bulkhead fittings, separates and maintains the sealed integrity of the aisle compartment. Additionally, this location is a natural low spot in the system, which enables easy draining of the rack fluid distribution and facilitates easy maintenance. The draining would be done via a drain port or valve on the compartment side of the bulkhead fitting.

Various controllers may execute various operations discussed above, including controlling the valves of the piping-container modules, controlling the leak detector, etc. Using data stored in associated memory and/or storage, the controller also executes one or more instructions stored on one or more non-transitory computer-readable media, which the controller may include and/or be coupled to, that may result in manipulated data. In some examples, the controller may include one or more processors or other types of controllers. In one example, the controller is or includes at least one processor. In another example, the controller performs at least a portion of the operations discussed above using an application-specific integrated circuit tailored to perform particular operations in addition to, or in lieu of, a general-purpose processor. As illustrated by these examples, examples in accordance with the present disclosure may perform the operations described herein using many specific combinations of hardware and software and the disclosure is not limited to any particular combination of hardware and software components. Examples of the disclosure may include a computer-program product configured to execute methods, processes, and/or operations discussed above. The computer-program product may be, or include, one or more controllers and/or processors configured to execute instructions to perform methods, processes, and/or operations discussed above.

Numbered examples are provided below:
Example 1. A piping-container module, comprising:
   a module body;
   a first portion formed in the module body, the first portion being configured to receive first liquid-cooling piping coupled to a cooling-distribution unit;
   a second portion formed in the module body, the second portion being configured to receive second liquid-cooling piping coupled to an equipment rack;
   a seal coupled to the first portion and the second portion; and
   a walking platform configured to be coupled to the module body, the walking platform being configured to enable a person to walk on the piping-container module.
Example 2. The piping-container module of example 1, wherein the first portion includes a first opening formed in the module body, the first opening being configured to receive a portion of a first inlet pipe of the first liquid-cooling piping, and a second opening formed in the module body, the second opening being configured to receive a portion of a first outlet pipe of the first liquid-cooling piping.
Example 3. The piping-container module of example 2, wherein the second portion includes a third opening formed in the module body, the third opening being configured to receive a portion of a second inlet pipe of the second liquid-cooling piping, and a fourth opening formed in the module body, the fourth opening being configured to receive a portion of a second outlet pipe of the second-liquid-cooling piping.
Example 4. The piping-container module of example 3, wherein each of the first opening, the second opening, the third opening and the fourth opening are formed in sides of the module body with each opening being in fluid communication with a basin formed in the module body.
Example 5. The piping-container module of example 3, wherein the first inlet pipe and the first outlet pipe of the first portion and the second inlet pipe and the second outlet pipe of the second portion are coupled to piping and valves disposed within a basin formed in the module body.
Example 6. The piping-container module of example 3, wherein the first inlet pipe and the first outlet pipe of the first portion and the second inlet pipe and the second outlet pipe of the second portion are coupled to at least one manifold disposed within a basin formed in the module body.
Example 7. The piping-container module of example 3, wherein
   the first inlet pipe is configured to connect the module body to the cooling-distribution unit to deliver relatively chilled coolant to the module body,
   the first outlet pipe is configured to connect the module body to the cooling-distribution unit to return relatively heated coolant to the cooling-distribution unit,
   the second inlet pipe is configured to connect the module body to the equipment rack to deliver the relatively chilled coolant to the equipment rack, and
   the second outlet pipe is configured to connect the module body to the equipment rack to return the relatively heated coolant to the module body.
Example 8. The piping-container module of example 7, wherein the first inlet pipe and the first outlet pipe of the first portion and the second inlet pipe and the second outlet pipe of the second portion are coupled to piping and valves disposed within a basin of the module body.
Example 9. The piping-container module of example 7, wherein the first inlet pipe and the first outlet pipe of the first portion and the second inlet pipe and the second outlet pipe of the second portion are coupled to at least one manifold disposed within a basin formed in the module body.
Example 10. The piping-container module of example 3, wherein the seal includes a first seal and a second seal secured to the module body, the first seal including a first sealing member secured to the module body at the first opening and a second sealing member secured to the module body at the second opening, and the second seal including a third sealing member secured to the module body at the third opening and a fourth sealing member secured to the module body at the fourth opening.
Example 11. The piping-container module of example 1**,** wherein the module body includes a basin formed therein.
Example 12. The piping-container module of example 11**,** further comprising a leak detector disposed in the basin to detect a fluid leak within the piping-container module.
Example 13. The piping-container module of example 11, wherein the seal includes a liner disposed within the basin.
Example 14. The piping-container module of example 11, wherein the walking platform is secured to the module body to enclose the basin.
Example 15. The piping-container module of example 11, wherein the walking platform includes one or more sections configured to span a width of the basin of the module body.
Example 16. The piping-container module of example 1, further comprising at least one transition cabinet configured to transition piping to the piping-container module.
Example 17. A system, comprising:
   at least two piping-container modules, each piping-container module including
   a module body,
   a first portion formed in the module body, the first portion being configured to receive first liquid-cooling piping coupled to a cooling-distribution unit,
   a second portion formed in the module body, the second portion being configured to receive second liquid-cooling piping coupled to an equipment rack,
   a seal coupled to the first portion and the second portion, and
   a walking platform configured to be coupled to the module body, the walking platform being configured to enable a person to walk on the piping-container module.
Example 18. The system of example 17, further comprising at least one transition cabinet configured to deliver relatively chilled coolant to the first liquid-cooling piping of a first piping-container module of the at least two piping-container modules from the cooling-distribution unit.
Example 19. The system of example 18, wherein the at least one transition cabinet further is configured to receive relatively heated coolant from the first piping-container module of the at least two piping-container modules.
Example 20. The system of example 17, wherein walking platforms of the at least two piping-container modules lie along a common plane.
Example 21. A method of distributing coolant from a cooling-distribution unit to at least one equipment rack containing electronic equipment requiring cooling, the method comprising:
   receiving relatively chilled coolant through a first portion of a piping-container module from first liquid-cooling piping coupled to the cooling-distribution unit;
   delivering the relatively chilled coolant through a second portion of the piping-container module from second liquid-cooling piping coupled to the at least one equipment rack;
   coupling a seal to the first portion and the second portion; and
   providing a walking platform configured to enable a person to walk on the first liquid-cooling piping and the second liquid-cooling piping.
Example 22. The method of example 21, wherein the first portion includes a first opening and a second opening and the second portion includes a third opening and a fourth opening, each of the first opening, the second opening, the third opening and the fourth opening being formed in a module body of a piping-container module, the first opening being configured to receive a portion of a first inlet pipe of the first liquid-cooling piping, the second opening being configured to receive a portion of a first outlet pipe of the first liquid-cooling piping, the third opening being configured to receive a portion of a second inlet pipe of the second liquid-cooling piping, and the fourth opening being configured to receive a portion of a second outlet pipe of the second-liquid-cooling piping.
Example 23. The method of example 22, further comprising coupling the first inlet pipe and the first outlet pipe of the first portion and the second inlet pipe and the second outlet pipe of the second portion to piping and valves disposed within a basin formed in the module body.
Example 24. The method of example 22, further comprising coupling the first inlet pipe and the first outlet pipe of the first portion and the second inlet pipe and the second outlet pipe of the second portion to at least one manifold disposed within a basin formed in the module body.
Example 25. The method of example 22, further comprising
   connecting the module body to the cooling-distribution unit with the first inlet pipe to deliver relatively chilled coolant to the module body,
   connecting the module body to the cooling-distribution unit with the first outlet pipe to return relatively heated coolant to the cooling-distribution unit,
   connecting the module body to the equipment rack with the second inlet pipe to deliver the relatively chilled coolant to the equipment rack, and
   connecting the module body to the equipment rack with the second outlet pipe to return the relatively heated coolant to the module body.

Having thus described several aspects of at least one embodiment, it is to be appreciated various alterations, modifications, and improvements will readily occur to those skilled in the art. Such alterations, modifications, and improvements are intended to be part of this disclosure and are intended to be within the scope of the disclosure. Accordingly, the foregoing description and drawings are by way of example only.

## Claims

1. A piping-container module (30), comprising:
a module body (42);
a first portion formed in the module body, the first portion being configured to receive first liquid-cooling piping (34, 36) coupled to a cooling-distribution unit (20);
a second portion formed in the module body, the second portion being configured to receive second liquid-cooling piping (34, 36) coupled to an equipment rack (14);
a seal (54, 56, 58, 60, 68) coupled to the first portion and the second portion; and
a walking platform configured to be coupled to the module body, the walking platform being configured to enable a person to walk on the piping-container module.

2. The piping-container module of claim 1, wherein the first portion includes a first opening (46) formed in the module body, the first opening being configured to receive a portion of a first inlet pipe of the first liquid-cooling piping, and a second opening (48) formed in the module body, the second opening being configured to receive a portion of a first outlet pipe of the first liquid-cooling piping.

3. The piping-container module of claim 2, wherein the second portion includes a third opening (50) formed in the module body, the third opening being configured to receive a portion of a second inlet pipe of the second liquid-cooling piping, and a fourth opening (52) formed in the module body, the fourth opening being configured to receive a portion of a second outlet pipe of the second-liquid-cooling piping.

4. The piping-container module of claim 3, wherein each of the first opening, the second opening, the third opening and the fourth opening are formed in sides of the module body with each opening being in fluid communication with a basin (44) formed in the module body.

5. The piping-container module of claim 3, wherein the first inlet pipe and the first outlet pipe of the first portion and the second inlet pipe and the second outlet pipe of the second portion are coupled to one or more of:
- piping and valves (104, 106) disposed within a basin formed in the module body; and
- at least one manifold (90, 92) disposed within a basin formed in the module body.

6. The piping-container module of any of claims 3 to 5, wherein
the first inlet pipe is configured to connect the module body to the cooling-distribution unit to deliver relatively chilled coolant to the module body,
the first outlet pipe is configured to connect the module body to the cooling-distribution unit to return relatively heated coolant to the cooling-distribution unit,
the second inlet pipe is configured to connect the module body to the equipment rack to deliver the relatively chilled coolant to the equipment rack, and
the second outlet pipe is configured to connect the module body to the equipment rack to return the relatively heated coolant to the module body.

7. The piping-container module of claim 6 in combination with claim 5, wherein the first inlet pipe and the first outlet pipe of the first portion and the second inlet pipe and the second outlet pipe of the second portion are coupled to one or more of:
- the piping and valves disposed within a basin of the module body; and
- the at least one manifold disposed within basin formed in the module body.

8. The piping-container module of any of claims 3 to 7, wherein the seal includes a first seal and a second seal secured to the module body, the first seal including a first sealing member (54) secured to the module body at the first opening (46) and a second sealing member (56) secured to the module body at the second opening (48), and the second seal including a third sealing member (58) secured to the module body at the third opening and a fourth sealing member (60) secured to the module body at the fourth opening.

9. The piping-container module of any of the above claims, wherein the module body includes a basin formed therein.

10. The piping-container module of claim 9, further comprising one or more of:
a leak detector disposed in the basin to detect a fluid leak within the piping-container module; and
a liner, wherein the seal includes the liner disposed within the basin.

11. The piping-container module of any of claim 9 or 10, wherein the walking platform:
is secured to the module body to enclose the basin; or
includes one or more sections configured to span a width of the basin of the module body; or
is secured to the module body to enclose the basin and includes one or more sections configured to span a width of the basin of the module body.

12. The piping-container module of any of the above claims, further comprising at least one transition cabinet configured to transition piping to the piping-container module.

13. A system, comprising:
at least two piping-container modules according to any of the above claims.

14. The system of claim 13, further comprising at least one transition cabinet configured to deliver relatively chilled coolant to the first liquid-cooling piping of a first piping-container module of the at least two piping-container modules from the cooling-distribution unit, wherein the at least one transition cabinet further is configured to receive relatively heated coolant from the first piping-container module of the at least two piping-container modules.

15. The system of claim 13 or of claim 14, wherein walking platforms of the at least two piping-container modules lie along a common plane.

16. A method of distributing coolant from a cooling-distribution unit to at least one equipment rack containing electronic equipment requiring cooling, the method comprising:
receiving relatively chilled coolant through a first portion of a piping-container module according to any of claims 1 to 12 from first liquid-cooling piping coupled to the cooling-distribution unit;
delivering the relatively chilled coolant through a second portion of the piping-container module from second liquid-cooling piping coupled to the at least one equipment rack;
coupling a seal to the first portion and the second portion; and
providing a walking platform configured to enable a person to walk on the first liquid-cooling piping and the second liquid-cooling piping.
